# EUROPEAN PATENT SPECIFICATION

(11) **EP 4 407 688 B1**
(45) Date of publication and mention of the grant of the patent: **27.08.2025**
(21) Application number: 21965142.9
(22) Date of filing: 25.11.2021
(51) Int. Cl.: H10D 30/47, H10D 30/01, H10D 62/85, H10D 62/17

(54) **HIGH ELECTRON MOBILITY TRANSISTOR, RADIO FREQUENCY TRANSISTOR, POWER AMPLIFIER, AND METHOD FOR PREPARING HIGH ELECTRON MOBILITY TRANSISTOR**
TRANSISTOR MIT HOHER ELEKTRONENMOBILITÄT, HOCHFREQUENZTRANSISTOR, LEISTUNGSVERSTÄRKER UND VERFAHREN ZUR HERSTELLUNG EINES TRANSISTORS MIT HOHER ELEKTRONENMOBILITÄT
TRANSISTOR À HAUTE MOBILITÉ D'ÉLECTRONS, TRANSISTOR RADIOFRÉQUENCE, AMPLIFICATEUR DE PUISSANCE ET PROCÉDÉ DE PRÉPARATION DE TRANSISTOR À HAUTE MOBILITÉ D'ÉLECTRONS

(43) Date of publication of application: 31.07.2024
(73) Proprietor: Huawei Technologies Co., Ltd., Shenzhen, Guangdong 518129 (CN)
(72) Inventor: HU, Bin, Shenzhen, Guangdong 518129 (CN); ZHU, Min, Shenzhen, Guangdong 518129 (CN); DUAN, Huantao, Shenzhen, Guangdong 518129 (CN)
(74) Representative: Pfenning, Meinig & Partner mbB
(86) International application number: PCT/CN2021/133250
(87) International publication number: WO 2023/092407

(56) References cited:
- CN-A- 109 560 118
- CN-A- 113 314 598
- CN-A- 113 314 598
- US-A1- 2005 151 255
- US-A1- 2007 164 314
- US-A1- 2010 276 732
- US-A1- 2019 334 023
- US-A1- 2020 273 974

## Description

### TECHNICAL FIELD

This application relates to the field of microelectronics technologies, and in particular, to a high electron mobility transistor, a power amplifier, and a preparation method for a high electron mobility transistor.

### BACKGROUND

US 2020/273974 A1 describes III-N devices having a stepped cap layer over the channel of the device, for which the III-N material is orientated in an N-polar orientation.

CN 113 314 598 A describes a diamond-based nitrogen polar surface gallium nitride high-electron-mobility transistor and a manufacturing method thereof.

US 2010/276732 A1 describes a semiconductor device comprising: a lower barrier layer composed of a layer of AlxGa1-xN (0≦x≦1) in a state of strain relaxation; and a channel layer composed of a layer of InyGa1-yN (0≦y≦1) disposed on said lower barrier layer, said channel layer having band gap that is smaller than band gap of said lower barrier layer and exhibiting compressive strain, wherein a gate electrode is formed over said channel layer via an insulating film and a source electrode and a drain electrode are formed over said channel layer, and wherein said insulating film is polycrystalline or amorphous.

US 2007/164314 A1 describes an N-polar III-nitride heterojunction JFET which includes a P-type III-nitride body under the gate electrode thereof.

US 2005/151255 A1 describes a GaN semiconductor device with improved heat resistance of the Schottky junction electrode and excellent power performance and reliability.

A wide bandgap semiconductor gallium nitride (GaN) material has advantages of a large bandgap, high breakdown field strength, a high polarization coefficient, a high electron mobility, and a high electron saturation drift velocity, and is gradually used in the field of power electronics and radio frequency.

Currently, a structure of a high electron mobility transistor based on gallium nitride has defects and needs to be improved.

### SUMMARY

This application provides a high electron mobility transistor having a low ohmic contact resistance, a power amplifier, and a preparation method for a high electron mobility transistor according to the independent claims.

According to one aspect of the invention, this application provides a high electron mobility transistor, including at least a channel layer, a barrier layer, and a substrate layer that are sequentially disposed, where a two-dimensional electron gas layer is formed in the channel layer, and the two-dimensional electron gas layer is in contact with the barrier layer; and the high electron mobility transistor further includes a source and a drain, where the source and the drain are located on the channel layer, and the source and the drain are in ohmic contact with the channel layer. The two-dimensional electron gas layer is generated through a polarization effect at a junction interface between the channel layer and the barrier layer. The two-dimensional electron gas layer is located in the channel layer, and the two-dimensional electron gas layer is in contact with the barrier layer. Therefore, a lower ohmic contact resistance may be obtained in a surface that is of the channel layer and that faces away from the barrier layer, or it may be understood that there is a lower ohmic contact resistance between the source and the channel layer and between the drain and the channel layer, so that the high electron mobility transistor can be better used in a high frequency and power scenario. Further, the barrier layer comprises a silicon-doped aluminum gallium nitride layer and an aluminum gallium nitride layer whose aluminum component is greater than 20% that are sequentially disposed in a direction away from the channel layer; and a thickness of the aluminum gallium nitride layer whose aluminum component is greater than 20% is between 1 nm and 20 nm

The two-dimensional electron gas layer is a virtual layer of two-dimensional electron gas generated through a polarization effect at a heterojunction interface of the channel layer and the barrier layer. The two-dimensional electron gas layer is located in the channel layer, and the two-dimensional electron gas layer is in contact with the barrier layer.

In an implementation, not falling under the scope of the present invention a material of the channel layer may be gallium nitride (GaN), and a material of the barrier layer may be aluminum gallium nitride (AlGaN). The high electron mobility transistor may implement a high electron mobility by using the two-dimensional electron gas generated through a polarization effect at a heterojunction interface of aluminum gallium nitride and gallium nitride.

In addition, in this embodiment provided in this application, the surface that is of the channel layer and that faces away from the barrier layer is a nitrogen (N) surface. Alternatively, it may be understood that a surface (namely, a surface that faces away from the substrate layer) of the high electron mobility transistor is a nitrogen surface. The channel layer, the barrier layer, and the substrate layer are sequentially grown and formed. Therefore, during preparation of the high electron mobility transistor provided in this embodiment of this application, a high electron mobility transistor with a nitrogen surface can be more easily obtained, and crystal quality of the nitrogen surface can be effectively ensured. In addition, compared with a high electron mobility transistor with a gallium (Ga) surface, the high electron mobility transistor with the nitrogen surface can implement a lower ohmic contact resistance. Therefore, the high electron mobility transistor with the nitrogen surface can be better used in a high frequency and power scenario.

In specific application, a material of the substrate layer may be silicon (Si), silicon carbide (SiC), diamond, or the like. In an implementation provided in this application, the substrate layer may be made of a diamond material. Because the diamond material has higher thermal conductivity, heat dissipation performance of the component can be effectively improved. In addition, in an implementation provided in this application, the channel layer, the barrier layer, and the substrate layer are sequentially grown and formed. Therefore, the diamond substrate layer may be directly grown on the barrier layer by using a process, for example, microwave plasma chemical vapor deposition (Microwave Plasma Chemical Vapor Deposition, MPCVD), so that preparation efficiency and quality of the substrate layer can be effectively improved.

For a gate, in an implementation, the gate may be disposed on the channel layer and in Schottky contact with the channel layer.

In addition, according to different structures of the high electron mobility transistor, the gate may alternatively be disposed on another structure.

For example, in an implementation provided in this application, the high electron mobility transistor may further include a nucleation layer. The nucleation layer is located on a side that is of the channel layer and that faces away from the barrier layer. The gate is located on the nucleation layer, and the gate is in Schottky contact with the nucleation layer. A material of the nucleation layer may be aluminum nitride (AlN), or may be another material that facilitates forming of the channel layer. This is not limited in this application.

In an implementation, not falling under the scope of the present invention the barrier layer may include gallium nitride aluminum.
According to the present invention, the barrier layer includes a silicon-doped aluminum gallium nitride layer and an aluminum gallium nitride layer whose aluminum component is greater than 20% that are sequentially disposed in a direction away from the channel layer. The silicon-doped aluminum gallium nitride layer can adjust an energy band, to prevent a hole from being bound. The aluminum gallium nitride layer with a larger aluminum component can effectively improve an electron gas concentration. In summary, performance of the high electron mobility transistor can be effectively improved by using the silicon-doped aluminum gallium nitride layer and the aluminum gallium nitride layer whose aluminum component is greater than 20%.

In an implementation, the high electron mobility transistor may further include a high resistance layer. Specifically, the high resistance layer is located between the barrier layer and the substrate layer. The nucleation layer, the channel layer, the barrier layer, the high resistance layer, and the substrate layer may be sequentially disposed. A material of the high resistance layer may be iron (Fe)-doped or carbon (C)-doped gallium nitride. A main function of the high resistance layer is to increase a resistance value of the high electron mobility transistor, so that the high electron mobility transistor can be used in an application scenario in which a high resistance value is required.

In addition, in an implementation, the high electron mobility transistor may also be a P-type (or normally closed) transistor. For example, the high electron mobility transistor includes the channel layer, the barrier layer, and the substrate layer that are sequentially disposed. In addition, there is a P-type doped (or hole-doped) gallium nitride layer on a side that is of the channel layer and that faces away from the barrier layer. In addition, the gate is in Schottky contact with the P-type doped gallium nitride layer. The source and the drain are in ohmic contact with the channel layer. In a final component structure, the high resistance layer, the nucleation layer, and the like mentioned in the foregoing embodiments may alternatively exist. Details are not described herein again.

According to another aspect, this application further provides a radio frequency transistor and a power amplifier, including any one of the foregoing high electron mobility transistors. Alternatively, it may be understood that the high electron mobility transistor provided in this application may be widely used in devices such as a base station, a radar, a mobile phone, and a notebook computer. A specific application scenario of the high electron mobility transistor is not limited in this application.

According to another aspect of the present invention, this application further provides a preparation method for a high electron mobility transistor, and the method includes: sequentially growing at least a channel layer, a barrier layer, and a substrate layer on a base material in a specific direction; removing the base material; and preparing a source and a drain on the channel layer, where the source and the drain are in ohmic contact with the channel layer. The base material may be a material like silicon (Si) or silicon carbide (SiC). It may be understood that a main function of the base material is to be used as a substrate used to grow an epitaxial structure like the channel layer and the barrier layer, to prepare the epitaxial structure. A material of the channel layer may be gallium nitride. In addition, the channel layer, the barrier layer, and the substrate layer are sequentially grown and formed. Therefore, during preparation of the high electron mobility transistor, a high electron mobility transistor with a nitrogen surface can be more easily obtained, and crystal quality of the nitrogen surface can be effectively ensured. According to the invention, the growing a barrier
layer comprises: sequentially growing, in the specific direction, a silicon-doped aluminum gallium nitride layer and an aluminum gallium nitride layer whose aluminum component is greater than 20%; and a thickness of the aluminum gallium nitride layer whose aluminum component is greater than 20% is between 1 nm and 20 nm

In an implementation, the preparation method may further include preparing a gate. The gate may be located on the channel layer, and the gate may be in Schottky contact with the channel layer.

Alternatively, in some preparation methods, before the growing a channel layer on a base material, the method may further include: growing a nucleation layer on the base material in the specific direction, where the channel layer is located on the nucleation layer.

In addition, during preparation of the gate, the gate may be located on the nucleation layer and in Schottky contact with the nucleation layer.

Alternatively, in some preparation methods, the nucleation layer may be removed after the base material is removed.

Alternatively, in some preparation methods, after the growing a nucleation layer on the base material in the specific direction, the method may further include: growing a buffer layer on the nucleation layer in the specific direction.

After the base material is removed, the nucleation layer and the buffer layer may be removed. The buffer layer is disposed to facilitate effective removal of the nucleation layer and the buffer layer itself, and quality of the channel layer is not affected.

According to the invention, the growing the barrier layer specifically includes: sequentially growing, in the specific direction, a silicon-doped aluminum gallium nitride layer and an aluminum gallium nitride layer whose aluminum composition is greater than 20%.

Alternatively, in some implementations, before the growing the substrate layer, the method may further include: growing a high resistance layer on a surface of the barrier layer in the specific direction. A main function of the high resistance layer is to increase a resistance value of the high electron mobility transistor, so that the high electron mobility transistor can be used in an application scenario in which a high resistance value is required.

In addition, based on the preparation method provided in this application, a P-type (or normally closed) high electron mobility transistor may be further prepared. For example, when the P-type high electron mobility transistor is prepared, a P-type doped (or hole-doped) gallium nitride layer may be added on the channel layer, and the gate is in Schottky contact with the P-type doped gallium nitride layer.

It may be understood that, in a specific application, a sequence of different processes may be adaptively adjusted based on an actual requirement in the preparation method in this application. This is not limited in this application.

### BRIEF DESCRIPTION OF DRAWINGS

FIG. 1 is a schematic of a structure of a current high electron mobility transistor according to an example, which is not an embodiment of the present invention but helpful for understanding certain aspects thereof;
FIG. 2 is a schematic of a structure of a high electron mobility transistor according to an embodiment of this application;
FIG. 3 is a schematic of a structure of another high electron mobility transistor according to an embodiment of this application;
FIG. 4 is a schematic of a structure of another high electron mobility transistor in a preparation process according to an embodiment of this application;
FIG. 5 is a schematic of a structure of another high electron mobility transistor according to an embodiment of this application;
FIG. 6 is a schematic of a structure of another high electron mobility transistor in a preparation process according to an embodiment of this application;
FIG. 7 is a schematic of a structure of another high electron mobility transistor in a preparation process according to an embodiment of this application;
FIG. 8 is a schematic of a structure of another high electron mobility transistor in a preparation process according to an embodiment of this application;
FIG. 9 is a schematic of a structure of another high electron mobility transistor in a preparation process according to an embodiment of this application;
FIG. 10 is a schematic of a structure of another high electron mobility transistor according to an embodiment of this application;
FIG. 11 is a schematic of a structure of another high electron mobility transistor according to an embodiment of this application;
FIG. 12 is a flowchart of a preparation method for a high electron mobility transistor according to an embodiment of this application;
FIG. 13 is a schematic of a structure of another high electron mobility transistor in a preparation process according to an embodiment of this application;
FIG. 14 is a schematic of a structure of another high electron mobility transistor in a preparation process according to an embodiment of this application;
FIG. 15 is a schematic of a structure of another high electron mobility transistor in a preparation process according to an embodiment of this application;
FIG. 16 is a schematic of a structure of another high electron mobility transistor in a preparation process according to an embodiment of this application;
FIG. 17 is a schematic of a structure of another high electron mobility transistor in a preparation process according to an embodiment of this application;
FIG. 18 is a schematic of a structure of another high electron mobility transistor in a preparation process according to an embodiment of this application; and
FIG. 19 is a schematic of a structure of another high electron mobility transistor according to an embodiment of this application.

### DESCRIPTION OF EMBODIMENTS

To make the objectives, technical solutions, and advantages of this application clearer, the following further describes this application in detail with reference to the accompanying drawings.

To facilitate understanding of a high electron mobility transistor provided in embodiments of this application, the following first describes an operating principle of the high electron mobility transistor.

The high electron mobility transistor (HEMT) achieves high electron mobility by using two-dimensional electron gas (2DEG) generated through a polarization effect at a heterojunction interface of aluminum gallium nitride (AlGaN)/gallium nitride (GaN). The two-dimensional electron gas means that motion of electrons in a direction perpendicular to a junction interface is bound by a potential well, and therefore the electrons are quantized, while motion of the electrons in a direction parallel to the junction interface is still free. Such an electron thin layer is called the two-dimensional electron gas.

A high electron mobility transistor can be used in microelectronics such as microwave radio frequency or power electronics. For example, in the field of microwave radio frequency, the high electron mobility transistor may be used as a power amplifier, and a main function of the high electron mobility transistor is to amplify a radio frequency signal inside an active antenna unit (AAU), and then transmit the radio frequency signal in a form of an electromagnetic wave through an antenna. In the field of power electronics, the high electron mobility transistor can be used as a power switch and drive. For example, in a terminal device like a mobile phone, a notebook computer, or a tablet computer, the high electron mobility transistor may be used as a switch in a charging circuit. In a device like a lidar, the high electron mobility transistor can be used as a main component of a drive.

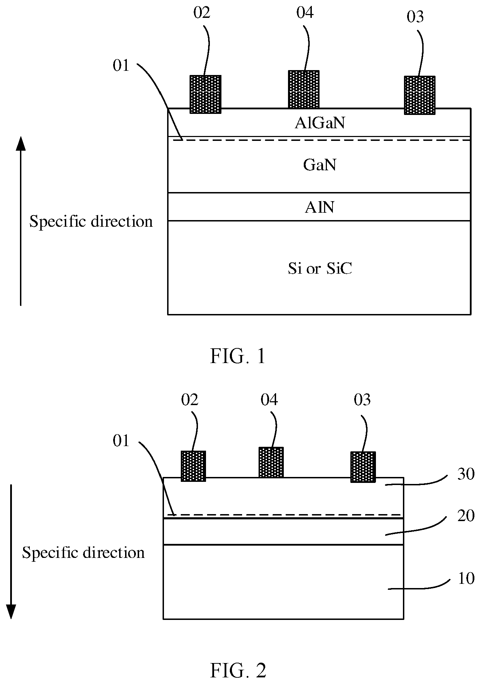

As shown in FIG. 1, in some high electron mobility transistors, silicon (Si) or silicon carbide (SiC) is usually used as a substrate, and then materials such as aluminum nitride (AlN), gallium nitride (GaN), and aluminum gallium nitride (AlGaN) are sequentially grown on the substrate for preparation. Then, a source 02, a drain 03, and a gate 04 are prepared on an upper surface of the AlGaN layer. A two-dimensional electron gas layer 01 is formed in the GaN layer, and the two-dimensional electron gas layer 01 is in contact with the AlGaN layer. When AlGaN is prepared, nitrogen (N) atoms in a compound are first formed, and then aluminum (Al) atoms and gallium (Ga) atoms are formed on the basis of the N atoms in a specific direction. Alternatively, it may be understood that, from a micro perspective, the N atoms, the Al atoms, and the Ga atoms in the AlGaN layer are sequentially arranged, so that a surface (for example, an upper surface in the figure) of a current high electron mobility transistor is a Ga surface. However, compared with the high electron mobility transistor with the Ga surface, a high electron mobility transistor with an N surface can implement a lower ohmic contact resistance. Therefore, the high electron mobility transistor with the N surface can be better used in a high frequency and power scenario. The high electron mobility transistor shown in FIG. 1 is not an embodiment of the present invention but helpful for understanding certain aspects thereof.

Therefore, an embodiment of this application provides a high electron mobility transistor according to claim 1 that can implement a lower ohmic contact resistance.

To make the objectives, technical solutions, and advantages of this application clearer, the following further describes this application in detail with reference to the accompanying drawings and specific embodiments.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It may be further understood that, in the following embodiments of this application, "at least one" means one, two, or more.

Reference to "an embodiment" or the like described in this specification means that one or more embodiments of this application include a particular feature, structure, or characteristic described in combination with the embodiment. Therefore, in this specification, statements, such as "in an embodiment", "in some implementations", and "in another implementation ", that appear at different places do not necessarily mean referring to a same embodiment, instead, the statements mean referring to "one or more but not all of embodiments", unless otherwise specifically emphasized in other ways. Terms "include", "have", and variants of the terms all mean "include but are not limited to", unless otherwise specifically emphasized in other ways.

As shown in FIG. 2, an embodiment of this application provides a high electron mobility transistor. The high electron mobility transistor includes a channel layer 30, a barrier layer 20, and a substrate layer 10. The channel layer 30, the barrier layer 20, and the substrate layer 10 are sequentially disposed in a specific direction. A two-dimensional electron gas layer 01 (represented by a dashed line in the figure) is formed in the channel layer 30, and the two-dimensional electron gas layer 01 is in contact with the barrier layer 20. A source 02, a gate 04, and a drain 03 are located on the channel layer 30, the source 02 and the drain 03 are in ohmic contact with the channel layer 30, and the gate 04 is in Schottky contact with the channel layer 30.

In the high electron mobility transistor provided in this application, the two-dimensional electron gas layer is located in the channel layer, and is in contact with the barrier layer. Therefore, a surface that is of the channel layer and that faces away from the barrier layer can implement a lower ohmic contact resistance, so that the high electron mobility transistor can be better used in a high frequency and power scenario.

The two-dimensional electron gas layer 01 is a virtual layer of two-dimensional electron gas generated through a polarization effect at a heterojunction interface of the channel layer 30 and the barrier layer 20. The two-dimensional electron gas layer 01 is located in the channel layer 30, and is in contact with the barrier layer 20.

Ohmic contact means that when a semiconductor is in contact with a metal, a barrier is usually formed. However, when doping density of the semiconductor is high, electrons may pass through the barrier through a tunnel effect, to form low-resistance ohmic contact. Good ohmic contact facilitates current input and output. Schottky contact means that when the gate 04 (for example, a metal material) and the channel layer 30 (for example, a semiconductor material) are in contact, an energy band of the semiconductor is bent at a boundary surface, to form a Schottky barrier.

In specific implementation, a material of the channel layer 30 may be GaN.

In this embodiment provided in this application, a surface (namely, a surface that faces away from the substrate layer 10) of the high electron mobility transistor is a nitrogen (N) surface. Therefore, the high electron mobility transistor can implement a lower ohmic contact resistance, or it may be understood that there is a lower ohmic contact resistance between the source 02 and the channel layer 30 and between the drain 03 and the channel layer 30, so that the high electron mobility transistor can be better used in a high frequency and power scenario. In addition, in this embodiment provided in this application, the channel layer 30, the barrier layer 20, and the substrate layer 10 are sequentially grown and formed. Therefore, during preparation of the high electron mobility transistor provided in this embodiment of this application, a high electron mobility transistor with an N surface can be more easily obtained, and crystal quality of the N surface can be effectively ensured. In addition, compared with a high electron mobility transistor with a gallium (Ga) surface, the high electron mobility transistor with the N surface can implement a lower ohmic contact resistance. Therefore, the high electron mobility transistor with the N surface can be better used in a high frequency and power scenario.

A thickness of the channel layer 30 may be any value between 50 nm and 500 nm, and a thickness of the barrier layer 20 may be any value between 10 nm and 100 nm. In specific application, the thicknesses of the channel layer 30 and the barrier layer 20 may be appropriately set based on an actual requirement. This is not specifically limited in this application. In addition, in another implementation, not falling under the scope of the present invention the material of the channel layer 30 may alternatively be gallium arsenide (GaAs) or the like, and the material of the barrier layer 20 may be gallium arsenide (AlGaAs) or the like. In specific applications not falling under the scope of the present invention the materials of the channel layer 30 and the barrier layer 20 may be appropriately selected and adjusted based on an actual requirement.

In specific application, a material of the substrate layer 10 may be silicon (Si), silicon carbide (SiC), diamond, or the like.

At room temperature (for example, 25°C), thermal conductivity of Si is about 150 W/mK, thermal conductivity of SiC is about 370 W/mK, and thermal conductivity of diamond is usually greater than 1000 W/mK.

Because the thermal conductivity of Si or SiC is relatively poor, a large thermal resistance is formed, and the thermal conductivity decreases with temperature rise, a problem of insufficient heat dissipation capability is faced in some high-power application scenarios. As a result, a high electron mobility transistor can run only at low power density, to ensure long-term reliability of the transistor. For example, theoretical output power density of a GaN HMET component may be more than 40 W/mm. However, when a substrate material is Si or SiC, to ensure long-term reliability of a high electron mobility transistor, the high electron mobility transistor needs to run at low power density (for example, less than 10 W/mm). This is not conducive to working performance of the high electron mobility transistor.

Therefore, the high electron mobility transistor with a diamond substrate can implement better heat dissipation. In addition, this further helps improve power density of the high electron mobility transistor.

When the substrate is made of a diamond material, in a preparation process, the GaN layer is usually bonded to the diamond substrate. However, a bonding process is complex and costly, which is not conducive to large-scale production. The bonding process requires a diamond surface to be very flat (for example, surface roughness is less than 1 nm) through processing. However, hardness of the diamond is high, and it is very difficult to process the surface to be very flat. In addition, a bonding process is also a monolithic process, and piece-by-piece processing and production may cause a problem of low production efficiency. In addition, during bonding, a bonding layer material, for example, silicon nitride (SiN), needs to be added between the GaN layer and the diamond substrate. Because the bonding layer material has a high thermal resistance, heat dissipation performance of the component is reduced.

In addition, because the diamond material has good thermal conductivity, heat dissipation performance of the component can be significantly improved.

In this embodiment provided in this application, the diamond material may be used as the substrate layer 10, to improve heat dissipation performance of the component.

In addition, in this embodiment provided in this application, the channel layer 30, the barrier layer 20, and the substrate layer 10 are sequentially grown and formed. Therefore, the diamond substrate layer 10 may be directly grown on the barrier layer 20 by using a process, for example, microwave plasma chemical vapor deposition (MPCVD), so that preparation efficiency and quality of the substrate layer 10 can be effectively improved.

Alternatively, it may be understood that, in the high electron mobility transistor provided in this application, when the substrate layer 10 is prepared, bonding between the substrate layer 10 and the barrier layer 20 by using a bonding process can be avoided, thereby reducing a manufacturing difficulty and manufacturing costs. In addition, because the bonding process is avoided, adding a bonding material (for example, SiN) with a large thermal resistance between the substrate layer 10 and the barrier layer 20 is avoided. Therefore, heat dissipation performance of the component can be ensured.

In specific implementation, the HMET component may have various structures.

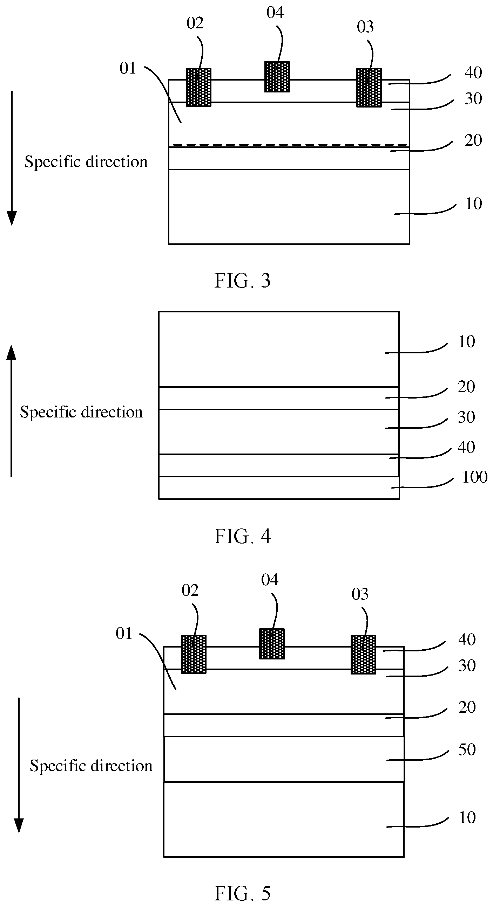

For example, as shown in FIG. 3, in another embodiment provided in this application, the high electron mobility transistor further includes a nucleation layer 40, and the nucleation layer 40 is located on a side that is of the channel layer 30 and that faces away from the barrier layer 20. A material of the nucleation layer 40 may be AlN. In addition, a thickness of the nucleation layer 40 may be any value between 10 nm and 50 nm. In specific application, the thickness of the nucleation layer 40 may be appropriately set based on an actual requirement. This is not specifically limited in this application.

Specifically, during preparation, to facilitate growth of the channel layer 30, the nucleation layer 40 may be first grown, and then the channel layer 30 is grown on the basis of the nucleation layer 40.

As shown in FIG. 4, it may be understood that, during preparation of the high electron mobility transistor, a base material 100 used to grow the channel layer 30 or the nucleation layer 40 is usually provided. The base material 100 is usually made of a Si or SiC material.

In a current preparation process, it is difficult to directly grow the channel layer 30 on the base material 100. Therefore, the nucleation layer 40 may be first grown on the base material 100, so that the channel layer 30 may be grown on the nucleation layer 40.

Alternatively, it may be understood that because the GaN channel layer 30 and the Si or SiC base material 100 are made of different materials, the channel layer 30 and the base material 100 usually have different lattice constants and different thermal expansion coefficients. If the GaN channel layer 30 is directly grown on the Si or SiC base material 100, a large quantity of hexagonal defects may occur between the channel layer 30 and the base material 100 due to problems such as lattice mismatch and thermal adaptation. Such defects are macro defects, and a crystal surface fluctuates greatly, which destroys continuity of a crystal film, and results in extremely difficult preparation of the component and low quality. In addition, when the GaN channel layer 30 is directly grown on the Si or SiC base material 100, oxygen impurity ionization causes the channel layer 30 to have a high background carrier concentration. Therefore, mobility of electrons is significantly reduced, and working performance of the component is affected.

Therefore, to grow a high-quality channel layer 30 with an N surface, the nucleation layer 40 may be first grown on the base material 100, and then the channel layer 30 is grown on the nucleation layer 40.

As shown in FIG. 3, in this embodiment provided in this application, the nucleation layer 40 generated due to a preparation process procedure may not be removed, to reduce preparation costs and simplify the preparation process. Therefore, a final product structure of the high electron mobility transistor may include the nucleation layer 40.

In addition, during preparation of the electrodes, the source 02 and the drain 03 may pass through the nucleation layer 40 and be in ohmic contact with the channel layer 30, and the gate 04 may be located on the nucleation layer 40 and be in Schottky contact with the nucleation layer 40.

It may be understood that, in another implementation, the gate 04 may also pass through the nucleation layer 40 and be in Schottky contact with the channel layer 30. This is not limited in this application.

In specific implementation, not falling under the scope of the present invention the barrier layer 20 may be an AlGaN material, or may be a doped AlGaN material.

According to the present invention, the barrier layer 20 includes a Si-doped AlGaN layer and an AlGaN layer whose Al component is greater than 20% that are sequentially disposed in a direction away from the channel layer 30. The Si-doped AlGaN layer can adjust an energy band to prevent a hole from being bound. The AlGaN layer with a larger Al component can effectively improve an electron gas concentration. In summary, performance of the high electron mobility transistor can be effectively improved by using the Si-doped AlGaN layer and the AlGaN layer whose Al component is greater than 20%.

It may be understood that in specific application, an overall thickness of the barrier layer 20 may be between 10 nm and 100 nm. A thickness of the Si-doped AlGaN layer may be between 10 nm and 50 nm. A thickness of the AlGaN layer whose Al component is greater than 20% is between 1 nm and 20 nm. In addition, in the AlGaN layer whose Al component is greater than 20%, the Al component may be 21%, 22%, 30%, or the like. A specific proportion of the Al component is not limited in this application. In addition, the overall thickness of the barrier layer 20, and the thickness of the Si-doped AlGaN layer may be adaptively adjusted based on an actual situation. This is not limited in this application.

In addition, as shown in FIG. 5, in another implementation, the high electron mobility transistor may further include a high resistance layer 50.

Specifically, the high resistance layer 50 is located between the barrier layer 20 and the substrate layer 10. The nucleation layer 40, the channel layer 30, the barrier layer 20, the high resistance layer 50, and the substrate layer 10 may be formed by sequentially growing in a specific direction.

The high resistance layer 50 may be iron (Fe)-doped or carbon (C)-doped GaN. A main function of the high resistance layer 50 is to increase a resistance value of the high electron mobility transistor, so that the high electron mobility transistor can be used in an application scenario in which a high resistance value is required.

In a specific application, a thickness of the high resistance layer 50 may be any value between 10 nm and 500 nm. In addition, in the high resistance layer 50, a specific concentration of doped Fe or C may be appropriately set based on an actual requirement. This is not limited in this application.

For ease of clearly understanding the technical solutions of this application, the following describes in detail a forming process of a high electron mobility transistor.

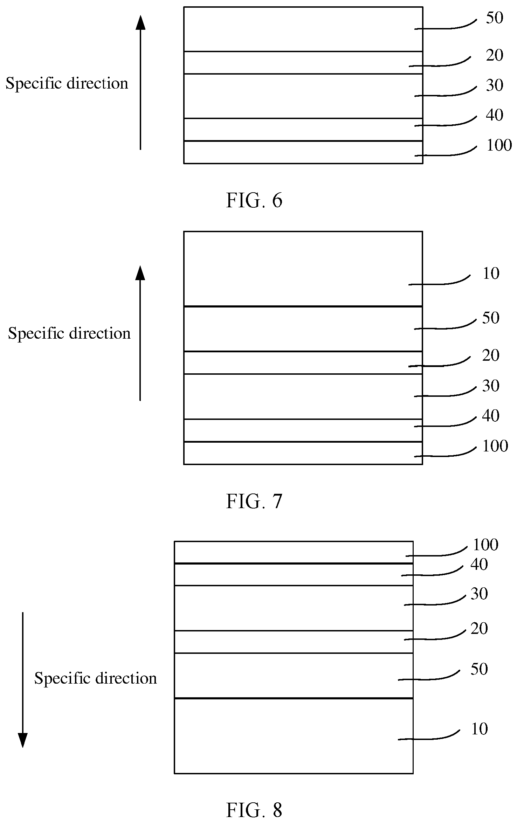

As shown in FIG. 6, a nucleation layer 40, a channel layer 30, a barrier layer 20, and a high resistance layer 50 may be sequentially grown on a base material 100 in a specific direction.

As shown in FIG. 7, the substrate layer 10 is grown on the high resistance layer 50.

As shown in FIG. 8, the component is flipped.

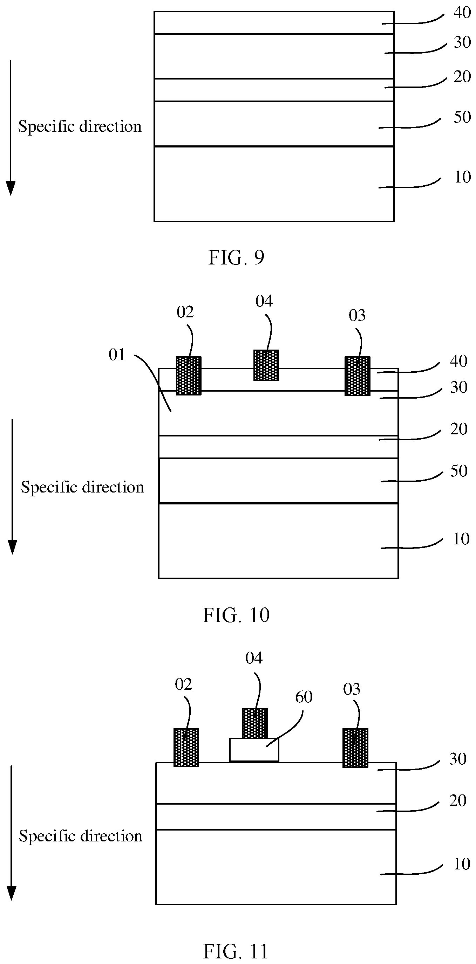

As shown in FIG. 9, the base material 100 is removed.

As shown in FIG. 10, a gate 04, a drain 03, and a source 02 are prepared on a surface of the nucleation layer 40. The gate 04 is in Schottky contact with the nucleation layer 40, and the source 02 and the drain 03 are in ohmic contact with the channel layer 30.

It may be understood that high electron mobility transistors are mainly classified into two types: an N-type (or normally open) transistor and a P-type (or normally closed) transistor. N-type high electron mobility transistors can be widely used in the field of microwave radio frequency. For example, the N-type high electron mobility transistor may be used in a device like a base station or a radar, and is configured to perform a function like amplifying a radio frequency signal. P-type high electron mobility transistors can be widely used in the field of power electronics. For example, in a terminal device like a mobile phone or a notebook computer, the P-type high electron mobility transistor may be used as a drive, a switch, or the like.

In the foregoing embodiment, an N-type (or normally open) high electron mobility transistor is used as an example for specific description.

Certainly, in another implementation, a P-type (or normally closed) high electron mobility transistor is adaptively designed based on the foregoing structure. Alternatively, it may be understood that, in the P-type high electron mobility transistor, a P-type doped (or hole-doped) GaN layer may be added based on the HMET component in any one of the foregoing embodiments.

For example, as shown in FIG. 11, in an embodiment provided in this application, a high electron mobility transistor includes a channel layer 30, a barrier layer 20, and a substrate layer 10 that are formed by sequentially growing in a specific direction. In addition, there is a P-type doped GaN layer 60 on a side that is of the channel layer 30 and that faces away from the specific direction. In addition, a gate 04 is in Schottky contact with the P-type doped GaN layer 60. A source 02 and a drain 03 are in ohmic contact with the channel layer 30.

It may be understood that, in a final component structure, the high resistance layer 50, the nucleation layer 40, and the like mentioned in the foregoing embodiments may alternatively exist. Details are not described herein again.

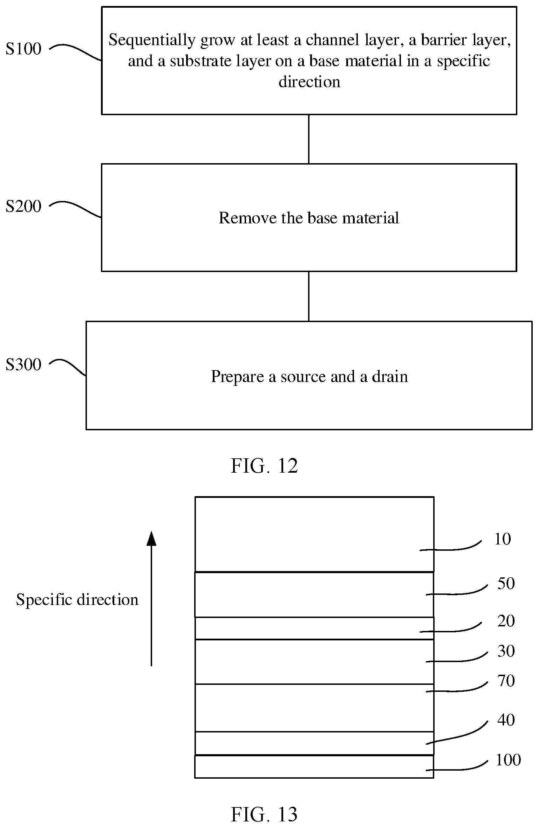

Refer to FIG. 12. An embodiment of this application further provides a preparation method for a high electron mobility transistor, and the method includes the following steps.

S100: Sequentially grow at least a channel layer, a barrier layer, and a substrate layer on a base material in a specific direction.

S200: Remove the base material.

S300: Prepare a source and a drain on the channel layer. The source and the drain are in ohmic contact with the channel layer.

In specific preparation, the specific direction refers to any direction in space. For example, in a conventional preparation manner, to facilitate obtaining of good forming quality, the layers of materials are usually formed by sequentially growing from bottom to top. Therefore, the specific direction may be a direction from bottom to top. It may be understood that in another implementation, the specific direction may be a direction from top to bottom, or may be a direction from left to right. This is not specifically limited in this application.

Refer to FIG. 6. In specific implementation, the base material 100 may be a material like silicon (Si) or silicon carbide (SiC). It may be understood that, in this embodiment of this application, a main function of the base material 100 is to be used as a substrate used to grow an epitaxial structure like the channel layer 30 and the barrier layer 20, to prepare the epitaxial structure.

In actual application, a material of the channel layer 30 may be GaN. In addition, according to the invention, the channel layer 30, the barrier layer 20, and the substrate layer 10 are sequentially grown and formed. Therefore, during preparation of the high electron mobility transistor in the preparation method provided in this embodiment of this application, a high electron mobility transistor with an N surface can be more easily obtained, and crystal quality of the N surface can be effectively ensured.

When the channel layer 30 and the barrier layer 20 are grown, the channel layer 30 and the barrier layer 20 may be prepared by using a process, for example, metal-organic chemical vapor deposition (MOCVD). Certainly, a preparation process of the channel layer 30 and the barrier layer 20 is not limited in this application.

The substrate layer 10 may be prepared by using a material such as Si, SiC, or diamond. For example, when a diamond material is used for the substrate layer 10, the diamond material may be directly grown on the barrier layer 20 by using a process, for example, microwave plasma chemical vapor deposition (MPCVD), to implement preparation of the substrate layer 10.

Alternatively, it may be understood that, as shown in FIG. 1, in a conventional preparation method, an AlN material, an AlGaN material, and a GaN material are usually grown sequentially on the substrate layer 10 of the Si or SiC material. Finally, the source 02, the drain 03, and the gate 04 are prepared on a surface of GaN (that is, a surface that faces away from the substrate layer 10).

Refer to FIG. 2. In the preparation method provided in this application, a base material (not shown in the figure) of a Si or SiC material may be used, and then the channel layer 30 (for example, GaN), the barrier layer 20 (for example, AlGaN), and the substrate layer 10 (for example, Si, SiC, or diamond) are grown on the base material. Then, the base material is removed, and the source 02, the drain 03, and the gate 04 are prepared on the channel layer 30.

According to the preparation method provided in this embodiment of this application, a high-quality high electron mobility transistor with an N surface can be obtained. In addition, diamond may be directly grown and formed, to facilitate preparation of the substrate layer 10.

Refer to FIG. 8 and FIG. 9 together. When the base material 100 is removed, an etching process, a mechanical grinding process, or a combination thereof may be used.

For example, the mechanical grinding process may be first used to perform thinning processing on the base material 100, and then the etching process is used to remove the residual base material 100. In this way, removal efficiency and quality of the base material 100 can be improved.

It may be understood that, in specific implementation, a process of removing the base material 100 is not limited in this application.

In addition, during specific preparation, to ensure forming quality of the channel layer 30, before the channel layer 30 is prepared on the base material 100, the method may further include: growing the nucleation layer 40 on the base material 100 in the specific direction, and then growing the channel layer 30 on the nucleation layer 40. A material of the nucleation layer 40 may be AlN, or C-doped or Fe-doped AlN. A specific material composition of the nucleation layer 40 is not limited in this application.

In a current preparation process, it is difficult to directly grow the channel layer 30 on the base material 100. Therefore, the nucleation layer 40 may be first grown on the base material 100, so that the channel layer 30 may be grown on the nucleation layer 40.

Alternatively, it may be understood that because the GaN channel layer 30 and the Si or SiC base material 100 are made of different materials, the channel layer 30 and the base material 100 usually have different lattice constants and different thermal expansion coefficients. If the GaN channel layer 30 is directly grown on the Si or SiC base material 100, a large quantity of hexagonal defects may occur between the channel layer 30 and the base material 100 due to problems such as lattice mismatch and thermal adaptation. Such defects are macro defects, and a crystal surface fluctuates greatly, which destroys continuity of a crystal film, and results in extremely difficult preparation of the component and low quality. In addition, when the GaN channel layer 30 is directly grown on the Si or SiC base material 100, oxygen impurity ionization causes the channel layer 30 to have a high background carrier concentration. Therefore, mobility of electrons is significantly reduced, and working performance of the component is affected.

Therefore, to grow a high-quality channel layer 30 with an N surface, the nucleation layer 40 may be first grown on the base material 100, and then the channel layer 30 is grown on the nucleation layer 40.

During specific implementation, after the base material 100 is removed, the nucleation layer 40 may not be removed, so that a preparation process procedure can be simplified, and preparation efficiency can be improved.

In addition, refer to FIG. 10. During preparation of the electrodes, the source 02 and the drain 03 need to keep in ohmic contact with the channel layer 30. Therefore, before the source 02 and the drain 03 are prepared, a via that penetrates to a surface of the channel layer 30 may be further prepared on the nucleation layer 40 in a mechanical drilling or etching manner. Finally, the source 02 and the drain 03 may be prepared in different vias, so that the source 02 and the drain 03 keep in ohmic contact with the channel layer 30.

The gate 04 may be directly prepared on a surface of the nucleation layer 40, and is in Schottky contact with the nucleation layer 40. Alternatively, a via that penetrates to the surface of the channel layer 30 may be prepared on the nucleation layer 40, and the gate 04 keeps in Schottky contact with the channel layer 30.

In addition, after the base material 100 is removed, the nucleation layer 40 may be further removed. For example, the nucleation layer 40 may be removed by using an etching process. Certainly, when the nucleation layer 40 is removed, another process like mechanical grinding may alternatively be used. This is not limited in this application.

Based on a current removal process, when the nucleation layer 40 is separately removed, quality of the surface of the channel layer 30 may be affected.

Therefore, as shown in FIG. 13, during specific preparation, the method may further include: after the nucleation layer 40 is grown, growing a buffer layer 70 on the surface of the nucleation layer 40 in the specific direction, and then growing the channel layer 30 on a surface of the buffer layer 70. A material of the buffer layer 70 may be AlGaN, and may be prepared by using a process like a metal-organic chemical vapor deposition process.

When the buffer layer 70 and the nucleation layer 40 are removed, a process combining thermal oxidation and wet etching may be used. Temperature required by a thermal oxidation process is generally between 550°C and 650°C, and a time is about 30 to 60 minutes. A main solution in a wet etching process is potassium hydroxide (KOH). In the thermal oxidation process, sufficient oxygen is first injected to fully oxidize AlN and AlGaN. AlN, AlGaN, and oxygen react to generate aluminum trioxide (Al₂O₃), gallium oxide (Ga₂O₃), and nitrogen (N₂), where the oxide Al₂O₃ and Ga₂O₃ may be etched off by a KOH solution of 70°C, and this method has little impact on the GaN channel layer 30. Alternatively, it may be understood that, in a high-temperature oxidation temperature condition, AlGaN is more likely to be oxidized than GaN. A main reason why AlGaN is more easily oxidized than GaN is that Gibbs free energy (Gibbs free energy) of Al₂O₃ obtained through reaction is greater than Gibbs free energy of Ga₂O₃ obtained through reaction. In this way, impact on the GaN channel layer 30 can be reduced as much as possible.

In addition, during preparation of the barrier layer 20, AlGaN may be directly grown on the surface of the channel layer 30 by using a metal-organic chemical vapor deposition method.

According to the present invention a Si-doped AlGaN layer and an AlGaN layer whose Al component is greater than 20% are sequentially grown on the surface of the channel layer 30 in the specific direction. The Si-doped AlGaN layer can adjust an energy band to prevent a hole from being bound. The AlGaN layer with a larger Al component can effectively improve an electron gas concentration. In summary, performance of the high electron mobility transistor can be effectively improved by using the Si-doped AlGaN layer and the AlGaN layer whose Al component is greater than 20%.

In addition, in some preparation methods, before the substrate layer 10 is grown, the method may further include: growing a high resistance layer 50 on the surface of the barrier layer 20 in the specific direction. The high resistance layer 50 may be iron (Fe)-doped or carbon (C)-doped GaN. The high resistance layer 50 can be prepared by using a process, for example, metal-organic chemical vapor deposition. A main function of the high resistance layer 50 is to increase a resistance value of the high electron mobility transistor, so that the high electron mobility transistor can be used in an application scenario in which a high resistance value is required.

Certainly, in specific implementation, a specific method for preparing the high resistance layer 50 is not limited in this application.

For ease of clearly understanding the technical solutions of this application, the following describes in detail another forming process of a high electron mobility transistor.

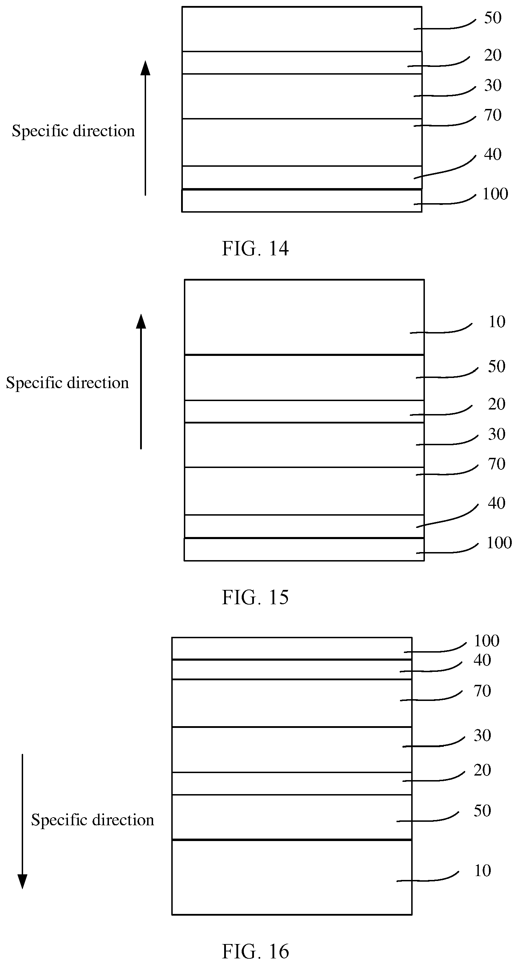

As shown in FIG. 14, a nucleation layer 40, a buffer layer 70, a channel layer 30, a barrier layer 20, and a high resistance layer 50 may be sequentially grown on a base material 100 in a specific direction.

As shown in FIG. 15, the substrate layer 10 is grown on the high resistance layer 50.

As shown in FIG. 16, the component is flipped.

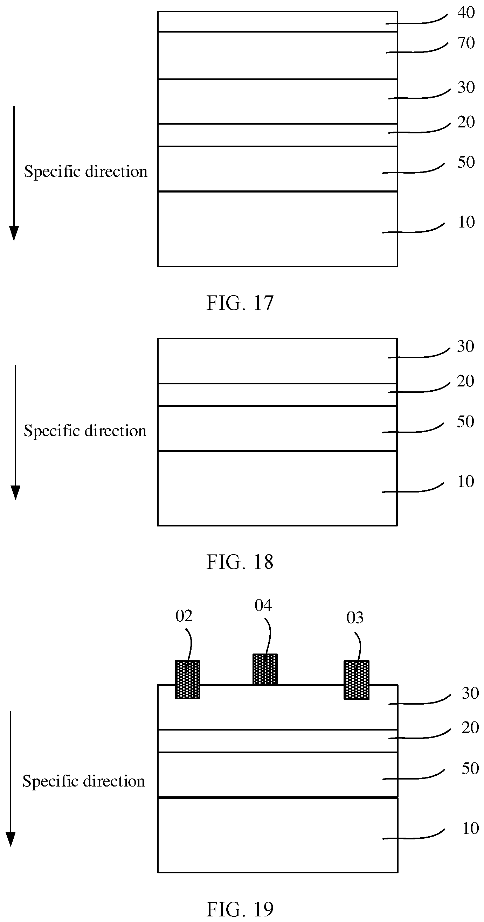

As shown in FIG. 17, the base material 100 is removed.

As shown in FIG. 18, the nucleation layer 40 and the buffer layer 70 are removed.

As shown in FIG. 19, a gate 04, a drain 03, and a source 02 are prepared on a surface of the channel layer 30. The gate 04 is in Schottky contact with the channel layer 30, and the source 02 and the drain 03 are in ohmic contact with the channel layer 30.

It may be understood that high electron mobility transistors are mainly classified into two types: an N-type (or normally open) transistor and a P-type (or normally closed) transistor. N-type high electron mobility transistors can be widely used in the field of microwave radio frequency. For example, the N-type high electron mobility transistor may be used in a device like a base station or a radar, and is configured to perform a function like amplifying a radio frequency signal. P-type high electron mobility transistors can be widely used in the field of power electronics. For example, in a terminal device like a mobile phone or a notebook computer, the P-type high electron mobility transistor may be used as a drive, a switch, or the like.

In the foregoing preparation method, a preparation method for an N-type (or normally open) high electron mobility transistor is used as an example for specific description.

Certainly, in another implementation, the foregoing preparation method may alternatively be applied to preparation of a P-type (or normally closed) high electron mobility transistor.

For example, as shown in FIG. 11, when the P-type high electron mobility transistor is prepared, a P-type doped GaN layer 60 may be added on the channel layer 30, and the gate 04 is in Schottky contact with the P-type doped GaN layer 60.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A high electron mobility transistor, comprising at least a channel layer (30), a barrier layer (20), and a substrate layer (10) that are sequentially disposed, wherein
a two-dimensional electron gas layer (01) is formed in the channel layer (30), and the two-dimensional electron gas layer (01) is in contact with the barrier layer (20); and
the high electron mobility transistor further comprises a source (02) and a drain (03), wherein the source (02) and the drain (03) are located on the channel layer (30), and the source (02) and the drain (03) are in ohmic contact with the channel layer (30);
wherein the barrier layer (20) comprises a silicon-doped aluminum gallium nitride layer and **characterized in that** it further comprises an aluminum gallium nitride layer whose aluminum component is greater than 20% and **in that** the silicon-doped aluminum gallium nitride layer and the aluminium gallium nitride layer whose aluminium component is greater than 20% are sequentially disposed in a direction away from the channel layer; and **in that** a thickness of the aluminum gallium nitride layer whose aluminum component is greater than 20% is between 1 nm and 20 nm.

2. The high electron mobility transistor according to claim 1, wherein a material of the channel layer (30) comprises gallium nitride, and a material of the barrier layer (20) comprises aluminum gallium nitride.

3. The high electron mobility transistor according to claim 2, wherein a surface that is of the channel layer (30) and that faces away from the barrier layer (20) is a nitrogen surface.

4. The high electron mobility transistor according to claim 1 or 2, wherein a material of the substrate layer (10) comprises diamond.

5. The high electron mobility transistor according to any one of claims 1 to 4, further comprising a gate (04), wherein the gate (04) is located on the channel layer (30), and the gate (04) is in Schottky contact with the channel layer (30).

6. The high electron mobility transistor according to any one of claims 1 to 4, further comprising a nucleation layer (40) and a gate (04), wherein
the nucleation layer (40) is located on a side that is of the channel layer (30) and that faces away from the barrier layer (20); and
the gate (04) is located on the nucleation layer (40), and the gate is in Schottky contact with the nucleation layer (40).

7. The high electron mobility transistor according to claim 6, wherein a material of the nucleation layer (40) comprises aluminum nitride.

8. The high electron mobility transistor according to any one of claims 1 to 7, further comprising a high resistance layer (50), wherein the high resistance layer (50) is located between the barrier layer (20) and the substrate layer (10);
wherein a material of the high resistance layer (50) comprises iron-doped or carbon-doped gallium nitride.

9. The high electron mobility transistor according to any one of claims 1 to 4, wherein a material of a side that is of the channel layer (30) and that faces away from the barrier layer (20) comprises P-type doped gallium nitride; and
the high electron mobility transistor further comprises a gate (04), and the gate (04) is in Schottky contact with the P-type doped gallium nitride.

10. A power amplifier, comprising the high electron mobility transistor according to any one of claims 1 to 9.

11. A preparation method for a high electron mobility transistor, comprising:
sequentially (S100) growing at least a channel layer, a barrier layer, and a substrate layer on a base material in a specific direction;
removing (S200) the base material; and
preparing (S300) a source and a drain on the channel layer, wherein the source and the drain are in ohmic contact with the channel layer;
**characterized in that** the growing (S100) a barrier layer comprises: sequentially growing, in the specific direction, a silicon-doped aluminum gallium nitride layer and an aluminum gallium nitride layer whose aluminum component is greater than 20%; and
**in that** a thickness of the aluminum gallium nitride layer whose aluminum component is greater than 20% is between 1 nm and 20 nm.

12. The preparation method according to claim 11, wherein before the growing (S100) a channel layer on a base material, the method further comprises:
growing a nucleation layer on the base material in the specific direction, wherein
the channel layer is located on the nucleation layer.

## Patentansprüche

1. Transistor mit hoher Elektronenmobilität, umfassend mindestens eine Kanalschicht (30), eine Sperrschicht (20) und eine Substratschicht (10), die nacheinander angeordnet sind, wobei
eine zweidimensionale Elektronengasschicht (01) in der Kanalschicht (30) ausgebildet ist und die zweidimensionale Elektronengasschicht (01) in Kontakt mit der Sperrschicht (20) steht; und
der Transistor mit hoher Elektronenmobilität ferner eine Source (02) und einen Drain (03) umfasst, wobei sich die Source (02) und der Drain (03) auf der Kanalschicht (30) befinden und die Source (02) und der Drain (03) in ohmschem Kontakt mit der Kanalschicht (30) stehen;
wobei die Sperrschicht (20) eine mit Silizium dotierte Aluminiumgalliumnitridschicht umfasst und **dadurch gekennzeichnet ist, dass** sie ferner eine Aluminiumgalliumnitridschicht umfasst, deren Aluminiumkomponente größer als 20 % ist, und dass die mit Silizium dotierte Aluminiumgalliumnitridschicht und die Aluminiumgalliumnitridschicht, deren Aluminiumkomponente größer als 20 % ist, nacheinander in einer Richtung weg von der Kanalschicht angeordnet sind; und dass eine Dicke der Aluminiumgalliumnitridschicht, deren Aluminiumkomponente größer als 20 % ist, zwischen 1 nm und 20 nm liegt.

2. Transistor mit hoher Elektronenmobilität nach Anspruch 1, wobei ein Material der Kanalschicht (30) Galliumnitrid umfasst und ein Material der Sperrschicht (20) Aluminiumgalliumnitrid umfasst.

3. Transistor mit hoher Elektronenmobilität nach Anspruch 2, wobei eine Oberfläche, die von der Kanalschicht (30) ist und die von der Sperrschicht (20) abgewandt ist, eine Stickstoffoberfläche ist.

4. Transistor mit hoher Elektronenmobilität nach Anspruch 1 oder 2, wobei ein Material der Substratschicht (10) Diamant umfasst.

5. Transistor mit hoher Elektronenmobilität nach einem der Ansprüche 1 bis 4, ferner umfassend ein Gate (04), wobei sich das Gate (04) auf der Kanalschicht (30) befindet und das Gate (04) in Schottky-Kontakt mit der Kanalschicht (30) steht.

6. Transistor mit hoher Elektronenmobilität nach einem der Ansprüche 1 bis 4, ferner umfassend eine Nukleationsschicht (40) und ein Gate (04), wobei
sich die Nukleationsschicht (40) auf einer Seite befindet, die von der Kanalschicht (30) ist und die von der Sperrschicht (20) abgewandt ist; und
sich das Gate (04) auf der Nukleationsschicht (40) befindet und das Gate in Schottky-Kontakt mit der Nukleationsschicht (40) steht.

7. Transistor mit hoher Elektronenmobilität nach Anspruch 6, wobei ein Material der Nukleationsschicht (40) Aluminiumnitrid umfasst.

8. Transistor mit hoher Elektronenmobilität nach einem der Ansprüche 1 bis 7, ferner umfassend eine Schicht (50) mit hohem Widerstand umfasst, wobei sich die Schicht (50) mit hohem Widerstand zwischen der Sperrschicht (20) und der Substratschicht (10) befindet;
wobei ein Material der Hochwiderstandsschicht (50) eisendotiertes oder kohlenstoffdotiertes Galliumnitrid umfasst.

9. Transistor mit hoher Elektronenmobilität nach einem der Ansprüche 1 bis 4, wobei ein Material einer Seite, die von der Kanalschicht (30) ist und die von der Sperrschicht (20) abgewandt ist, P-dotiertes Galliumnitrid umfasst; und
der Transistor mit hoher Elektronenmobilität ferner ein Gate (04) umfasst und das Gate (04) in Schottky-Kontakt mit dem P-dotierten Galliumnitrid steht.

10. Leistungsverstärker, umfassend den Transistor mit hoher Elektronenmobilität nach einem der Ansprüche 1 bis 9.

11. Herstellungsverfahren für einen Transistor mit hoher Elektronenmobilität, umfassend:
sequenzielles (S100) Aufbauen mindestens einer Kanalschicht, einer Sperrschicht und einer Substratschicht auf einem Basismaterial in einer spezifischen Richtung;
Entfernen (S200) des Basismaterials; und
Herstellen (S300) einer Source und eines Drains auf der Kanalschicht, wobei die Source und der Drain in ohmschem Kontakt mit der Kanalschicht stehen;
**dadurch gekennzeichnet, dass** das Aufbauen (S100) einer Sperrschicht Folgendes umfasst: sequenzielles Aufbauen einer siliziumdotierten Aluminiumgalliumnitridschicht und einer Aluminiumgalliumnitridschicht, deren Aluminiumanteil größer als 20 % ist, in der spezifischen Richtung; und
dass die Dicke der Aluminiumgalliumnitridschicht, deren Aluminiumanteil größer als 20 % ist, zwischen 1 nm und 20 nm liegt.

12. Herstellungsverfahren nach Anspruch 11, wobei das Verfahren vor dem Aufbauen (S100) einer Kanalschicht auf einem Basismaterial ferner Folgendes umfasst:
Aufbauen einer Nukleationsschicht auf dem Basismaterial in der spezifischen Richtung, wobei sich die Kanalschicht auf der Nukleationsschicht befindet.

## Revendications

1. Transistor à haute mobilité d'électrons, comprenant au moins une couche de canal (30), une couche barrière (20), et une couche de substrat (10) disposées séquentiellement, dans lequel
une couche de gaz d'électrons bidimensionnelle (01) est formée dans la couche de canal (30), et la couche de gaz d'électrons bidimensionnelle (01) est en contact avec la couche barrière (20) ; et
le transistor à haute mobilité d'électrons comprend également une source (02) et un drain (03), dans lequel la source (02) et le drain (03) sont situés sur la couche de canal (30), et la source (02) et le drain (03) sont en contact ohmique avec la couche de canal (30) ;
dans lequel la couche barrière (20) comprend une couche de nitrure d'aluminium et de gallium dopée au silicium et **caractérisée en ce qu'**elle comprend également une couche de nitrure d'aluminium et de gallium dont la composante en aluminium est supérieure à 20 % et **en ce que** la couche de nitrure d'aluminium et de gallium dopée au silicium et la couche de nitrure d'aluminium et de gallium dont la composante en aluminium est supérieure à 20 % sont disposées séquentiellement dans une direction s'éloignant de la couche de canal ; et **en ce qu'**une épaisseur de la couche de nitrure d'aluminium et de gallium dont la composante en aluminium est supérieure à 20 % est comprise entre 1 nm et 20 nm.

2. Transistor à haute mobilité d'électrons selon la revendication 1, dans lequel un matériau de la couche de canal (30) comprend du nitrure de gallium, et un matériau de la couche barrière (20) comprend du nitrure de gallium d'aluminium.

3. Transistor à haute mobilité d'électrons selon la revendication 2, dans lequel une surface qui compose la couche de canal (30) et qui est tournée à l'opposé de la couche barrière (20) est une surface d'azote.

4. Transistor à haute mobilité d'électrons selon la revendication 1 ou 2, dans lequel un matériau de la couche de substrat (10) comprend du diamant.

5. Transistor à haute mobilité d'électrons selon l'une quelconque des revendications 1 à 4, comprenant également une grille (04), dans lequel la grille (04) est située sur la couche de canal (30), et la grille (04) est en contact Schottky avec la couche de canal (30).

6. Transistor à haute mobilité d'électrons selon l'une quelconque des revendications 1 à 4, comprenant également une couche de nucléation (40) et une grille (04), dans lequel la couche de nucléation (40) est située sur un côté de la couche de canal (30) qui est opposé à la couche barrière (20) ; et
la grille (04) est située sur la couche de nucléation (40), et la grille est en contact Schottky avec la couche de nucléation (40).

7. Transistor à haute mobilité d'électrons selon la revendication 6, dans lequel un matériau de la couche de nucléation (40) comprend du nitrure d'aluminium.

8. Transistor à haute mobilité d'électrons selon l'une quelconque des revendications 1 à 7, comprenant également une couche à haute résistance (50), dans lequel la couche à haute résistance (50) est située entre la couche barrière (20) et la couche de substrat (10) ;
dans lequel un matériau de la couche à haute résistance (50) comprend du nitrure de gallium dopé au fer ou au carbone.

9. Transistor à haute mobilité d'électrons selon l'une quelconque des revendications 1 à 4, dans lequel un matériau d'une face de la couche de canal (30) opposée à la couche barrière (20) comprend du nitrure de gallium dopé de type P ; et
le transistor à haute mobilité d'électrons comprend également une grille (04), et la grille (04) est en contact Schottky avec le nitrure de gallium dopé de type P.

10. Amplificateur de puissance, comprenant le transistor à haute mobilité d'électrons selon l'une quelconque des revendications 1 à 9.

11. Procédé de préparation d'un transistor à haute mobilité d'électrons, comprenant :
la croissance séquentielle (S100) d'au moins une couche de canal, une couche barrière, et une couche de substrat sur un matériau de base dans une direction spécifique ;
le retrait (S200) du matériau de base ; et
la préparation (S300) d'une source et d'un drain sur la couche de canal, dans lequel la source et le drain sont en contact ohmique avec la couche de canal ;
**caractérisé en ce que** la croissance (S100) d'une couche barrière comprend : la croissance séquentielle, dans la direction spécifique, d'une couche de nitrure d'aluminium et de gallium dopé au silicium et d'une couche de nitrure d'aluminium et de gallium dont la composante aluminium est supérieure à 20 % ; et
**en ce que** l'épaisseur de la couche de nitrure d'aluminium et de gallium dont la composante aluminium est supérieure à 20 % est comprise entre 1 nm et 20 nm.

12. Procédé de préparation selon la revendication 11, dans lequel, avant la croissance (S100) d'une couche de canal sur un matériau de base, le procédé comprend également :
la croissance d'une couche de nucléation sur le matériau de base dans la direction spécifique, dans lequel la couche de canal est située sur la couche de nucléation.
